# FASCICULE DE BREVET EUROPEEN

(11) **EP 1 550 517 B1**
(45) Date de publication et mention de la délivrance du brevet: **10.09.2008**
(21) Numéro de dépôt: 04107061.6
(22) Date de dépôt: 30.12.2004
(51) Int. Cl.: B08B 3/08, H01L 21/306

(54) **Procede de nettoyage par voie humide d'une surface notamment en un materiau de type Silicium Germanium**
Verfahren zum Nassreinigen von einer Oberfläche, insbesondere von einem Material wie Silizium-Germanium
Method for wet cleaning a surface, particularly a surface made of a material like silicon-germanium

(30) Priorité: 31.12.2003 FR 0351239
(43) Date de publication de la demande: 06.07.2005
(73) Titulaire: COMMISSARIAT A L'ENERGIE ATOMIQUE, 75015 Paris (FR)
(72) Inventeur: Abbadie, Alexandra, 38240 Meylan (FR); BESSON, Pascal, 38220 Notre dame de Mesage (FR); Semeria, Marie-Noelle, 38000 Grenoble (FR)
(74) Mandataire: Poulin, Gérard

(56) Documents cités:
- EP-A- 0 952 609
- EP-A- 1 005 072
- US-A- 5 470 393
- F. TARDIF ET AL.: "Diluted dynamic clean: "DDC"" PROCEEDINGS OF THE 3RD INTERNATIONAL SYMPOSIUM ON ULTRA CLEAN PROCESSING OF SILICON SURFACES, ANTWERP, BELGIUM, 1996, pages 175-178, XP008034103 LEUVEN,BELGIUM, ACCO, BELGIUM
- F. TARDIF ET AL.: "New aspects of the diluted dynamic clean process" ULTRA CLEAN PROCESSING OF SILICON SURFACES. FOURTH INTERNATIONAL SYMPOSIUM, OSTEND, BELGIUM, 1999, pages 19-22, XP008034026 SOLID STATE PHENOMENA , SCITEC PUBLICATIONS, SWITZERLAND

## Description

La présente invention concerne un procédé de nettoyage par voie humide d'une surface, en particulier d'une surface en un matériau de type silicium-germanium et notamment en un matériau Si₁₋ₓGeₓ, où x est supérieur à 0 et inférieur à 1, de préférence x est dans la plage de 0,1 à 0,9, de préférence encore de 0,1 à 0,7.

Le domaine technique de l'invention peut, de manière générale, être défini comme celui du nettoyage, de la décontamination de surfaces, en particulier de surfaces de matériaux utilisés en microélectronique optique ou électronique, notamment de surfaces de matériaux de types alliages silicium-germanium, tels que le Si₁₋ₓGeₓ poli et cristallin. Les contaminants qui peuvent se trouver sur ces surfaces peuvent être de toutes natures : particulaires, organiques, minéraux, métalliques, etc... .

En effet, le développement constant des circuits intégrés micro-électroniques, basés sur le silicium CMOS, s'effectue grâce à l'amélioration de leurs performances et la miniaturisation de leurs composants élémentaires. Cependant, du fait d'une densité d'interconnexions toujours plus importante, le silicium apparaît, dans un proche avenir, comme une limitation physique majeure. Le calendrier de lancement de l'association de l'industrie des semi-conducteurs ("SIA (Semiconductor Industry Association) roadmap" en anglais) prévoit alors l'utilisation de nouveaux matériaux. Un des matériaux présentant le plus fort potentiel, avec de nombreuses possibilités d'intégration, vers des architectures plus performantes, est le germanium sous forme d'alliage de silicium-germanium.

Le matériau SiGe est déposé par épitaxie sur des substrats silicium. Sur ces substrats, de fines couches de silicium, dites « en tension », peuvent être déposées. Ce silicium en tension sur SiGe apparaît fort avantageux de part les propriétés électroniques qu'il confère aux composants élémentaires tels que le MOSFET (Metal-Oxide Semiconductor - Field Effect Transistor) ou aux circuits intégrés, de type CMOS.

Le silicium contraint peut être une couche enterrée ou en surface, et il augmente fortement la mobilité des électrons. Différents procédés ont été décrits pour la formation de ce silicium contraint sur SiGe, utilisant notamment le procédé silicium sur isolant ("Silicon On Insulator" ou "SOI" en anglais).

Ainsi, plusieurs procédés de fabrication de ces substrats relaxés SiGe ont été décrits, comme par exemple dans le document [1]. Une de leur caractéristique principale est la présence d'ondulations de surface. Ces ondulations (phénomène dit de « cross-hatch ») proviennent de la présence de dislocations qui se forment et se propagent dans une couche graduelle épaisse (plusieurs microns) à la base de ces substrats. Elles sont nécessaires pour leur quasi-totale relaxation, le but étant de maintenir en surface la plus faible densité de défauts possible. De cette structure, il en résulte après épitaxie une rugosité de surface élevée (plusieurs nm), croissante avec le pourcentage en Ge de l'alliage. Un polissage mécano-chimique (« CMP ») tel que décrit dans le document [2] est alors nécessaire, avant report d'une couche de Si Ge ou ré-épitaxie de silicium contraint, pour supprimer cette rugosité et la quasi-totalité des ondulations de surface, afin d'obtenir une rugosité de surface finale inférieure à 1 nm.

Un procédé de nettoyage par voie humide optimisé est donc primordial après le polissage mécano-chimique ("CMP"). Il doit être performant pour retirer la contamination introduite par le polissage qui est composée notamment de micro et nano particules, de contamination organique et de contamination métallique, sans pour cela dégrader la morphologie de surface initiale. Ce point est particulièrement important en ce qui concerne les substrats relaxés SiGe qui présentent des propriétés chimiques différentes envers certaines des solutions de nettoyage couramment utilisées en micro-électronique.

Ainsi, une solution de type SC1 (« Standard Cleaning 1 ») qui constitue en partie le nettoyage dit RCA ("Radio Corporation of America"), le plus utilisé actuellement sur silicium et autres matériaux, provoque une attaque virulente sur les surfaces SiGe. Même sur des temps courts et à basse température, ce traitement peut engendrer une création de micro-rugosité de surface, voire une forte résurgence des ondulations de surface, non compatible avec les applications électroniques envisagées. Cette sensibilité envers les solutions SC1 mais aussi SC2 (« Standard Cleaning 2 ») pour des teneurs en germanium supérieures à 50 %, est fonction du pourcentage en germanium de l'alliage et de la température de la solution. L'effet rugosifiant marqué de ce type de solution sur la surface de substrats Si₁₋ₓGeₓ (x=0,3 à 0,7) a été récemment rapporté dans le document [3]. L'utilisation de telles chimies est d'ores et déjà rédhibitoire pour une intégration technologique de matériaux SiGe à forte teneur en Ge (≥ 30 %).

Un procédé de nettoyage par voie humide visant à remédier aux inconvénients du procédé de nettoyage "RCA" classique a été décrit dans la littérature pour des substrats en silicium. Il s'agit du procédé dénommé Nettoyage dynamique dilué (« Diluted Dynamic Clean » ou « DDC » en anglais) qui repose fondamentalement sur l'utilisation de solutions de produits chimiques diluées, à température ambiante et associe deux bains chimiques préparés dans des réservoirs en quartz, l'un de ces bains, dédié à l'injection de produits chimiques, étant recirculé et filtré.

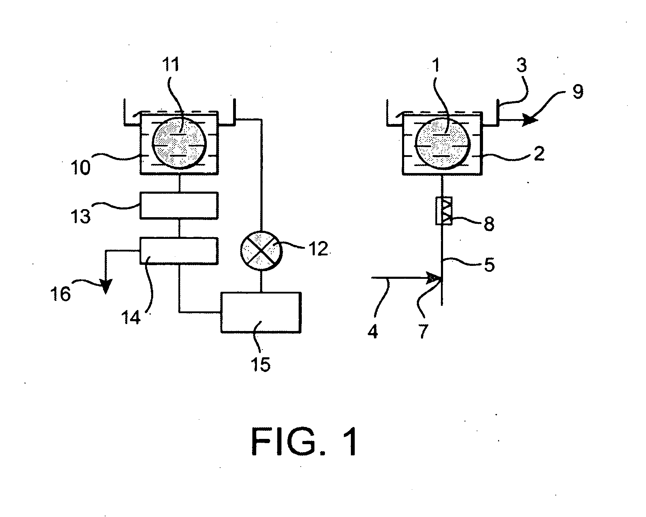

Ce procédé est en particulier décrit dans les documents [4] et [5] relatifs au nettoyage de prédiffusion sur oxyde de grille et est illustré sur la figure 1 : il met en oeuvre un bain (1), dans un réservoir de rinçage (2), à débordement (3), dans lequel de petites quantités de réactifs tels que de l'acide chlorhydrique ou de l'ozone gazeux sont injectés ensemble ou en alternance (4), dans un courant d'eau désionisée (5), qui alimente le réservoir (6).

Sur la figure 1, on note que l'injection (7) des réactifs tels que HCl ou O₃ se fait sur la canalisation d'alimentation (5) en eau désionisée du réservoir (2) à débordement, en aval d'un mélangeur statique (8) qui permet d'homogénéiser le mélange d'eau désionisée et de réactifs grâce à la recirculation des fluides qui est réalisée par ledit mélangeur statique (8) .

L'excès de bain chimique du réservoir est généralement recueilli par débordement (3) et est rejeté (9). Un tel réservoir permet la mise en oeuvre en alternance du procédé de nettoyage et du rinçage associé dans le même bain. Il en résulte que l'espace normalement occupé par le bain de rinçage peut être éliminé. Si la quantité de produits chimiques est négligeable dans le cas d'un nettoyage par des solutions diluées, le débordement peut être directement rejeté de sorte que les substrats, par exemple les plaquettes nettoyées sont toujours en contact avec des réactifs frais.

Un autre réservoir (10) contient un bain (11) constitué par une solution diluée, généralement à 1%, d'acide fluorhydrique, dans de l'eau désionisée. Cet autre réservoir, afin de limiter les rejets fluorés, comprend une boucle de recirculation munie généralement d'une pompe (12), d'un filtre (13), d'un dispositif de désorption de l'oxygène (14) pour éliminer en continu les gaz dissous, et d'un purificateur (15) chimique pour éliminer les métaux nobles. L'oxygène recueilli est évacué par la canalisation (16).

Une séquence de nettoyage par voie humide adaptée au nettoyage de prédiffusion sur oxyde de grille avec des substrats en silicium comprend donc les étapes successives suivantes :
- traitement avec de l'eau désionisée à 3 ppm de O₃ [4], ou 20 ppm de O₃ [5], pendant 5 minutes pour éliminer les métaux nobles et les composés organiques ;
- traitement avec une solution de HF à 1% acidifiée par 1% de HCl pendant plus de 0,5 minutes (« overetch ») pour éliminer l'oxyde sacrificiel et les métaux ;
- rinçage pendant 5 minutes à l'eau désionisée (sans autre additif) ;
- traitement avec de l'eau désionisée à 3 ppm de O₃ pendant 10 minutes, puis avec la solution de HF/HCl décrite ci-dessus pendant 1 minute, afin d'éliminer les particules ;
- rinçage pendant 5 minutes à l'eau désionisée acidifiée par HCl ;
- traitement avec de l'eau ozonisée à 3 ppm, et acidifiée avec de l'HCl à 0,01%, pour réaliser une passivation finale.

Les inconvénients présentés par le procédé des documents [4] et [5] appliqué aux substrats en Si sont notamment les suivants :

La gravure du silicium est très difficile à contrôler car le silicium est très sensible à l'attaque par HF/HCl ; le temps de désoxydation doit être ajusté très finement de façon à éviter une rugosification du silicium ; une consommation excessive de silicium entraîne des problèmes sur les étapes des procédés de fabrication de dispositifs ultérieures : tels que des problèmes d'alignement, de dépôt de couches, et sur la qualité de croissance des couches par épitaxie.

Par ailleurs, le procédé des documents [4] et [5] est spécifiquement conçu pour et adapté pour le nettoyage de prédiffusion sur oxyde de grille de substrats et surfaces en silicium, et les étapes de ce procédé, la succession de celles-ci, leur durée, les réactifs spécifiques mis en oeuvre lors de chacune des étapes ont été spécifiquement optimisés pour éliminer la contamination qu'elle soit organique, métallique, particulaire ou autre de tels substrats, spécifiquement en silicium, et l'efficacité de ce procédé n'a été démontrée que pour des surfaces en silicium.

Il existe donc un besoin pour un procédé de nettoyage par voie humide de surfaces, qui présente des performances, une efficacité améliorées pour le nettoyage des substrats en silicium, et il existe en particulier un besoin pour un procédé de nettoyage de surfaces en alliage silicium-germanium, par exemple de surfaces en Si₁₋ₓGeₓ (ou x est supérieur à 0 et inférieur à 1, par exemple x va de 0,1 à 0,9) qui tout en assurant un nettoyage d'une grande efficacité, et en permettant une élimination de toutes les contaminations qu'elles soient organiques, métalliques, particulaires ou autres, au moins équivalente à celle du procédé de nettoyage classique « RCA » ne présente pas les inconvénients de ce dernier.

En d'autres termes, il existe un besoin pour un procédé de nettoyage de surfaces par voie humide, en particulier de surface en alliage silicium-germanium qui soit non seulement très efficace et réalise l'élimination totale de tous les contaminants mais qui ne provoque pas de rugosification du substrat et de résurgences d'ondulations de surface.

Ce procédé doit par ailleurs être fiable, facile à mettre en oeuvre, comporter un nombre limité d'étapes, être relativement de courte durée, utiliser de faibles quantités de réactifs facilement disponibles, et réduire les rejets dans l'environnement.

Le but de l'invention est de fournir un procédé de nettoyage par voie humide de surfaces, en particulier de surface en alliage silicium-germanium qui, entre autres, réponde aux besoins et satisfasse aux exigences énumérées ci-dessus.

Le but de l'invention est encore de fournir un tel procédé de nettoyage par voie humide qui ne présente pas les inconvénients, limitations, défauts et désavantages des procédés de nettoyage de l'art antérieur et qui résolve les problèmes de l'art antérieur.

Ce but et d'autres encore sont atteints, conformément à l'invention, par un procédé de nettoyage par voie humide d'une surface en au moins un matériau choisi parmi le silicium, les alliages silicium-germanium, les semiconducteurs de type A(III) B(V), et les matériaux cristallins épitaxiés tels que le germanium, dans lequel on réalise les étapes successives suivantes :
a) on met en contact la surface avec une solution de HF à une concentration de 0,2 à 2% en volume, de préférence de 1% en volume, dans de l'eau désionisée (EDI), pendant une durée inférieure ou égale à 10 minutes, de préférence de 1 à 5 minutes, par exemple de 4 minutes, le pH de ladite solution étant maintenu à une valeur de 1 à 2, de préférence voisine de 1, pendant toute la durée de la mise en contact ;
b) on rince la surface avec de l'eau désionisée et acidifiée, pendant une durée de 1 à 5 minutes, de préférence de 1 à 3 minutes, par exemple de 3 minutes, puis on ajoute un agent oxydant puissant à l'eau désionisée, et on poursuit le rinçage pendant une durée de 5 à 10 minutes, de préférence de 5 à 7 minutes, par exemple de 7 minutes ; le pH étant maintenu à une valeur inférieure ou égale à 5, de préférence de 3 à 5, pendant toute l'étape b) ;
c) on répète éventuellement l'étape a), de 1 à 2 fois, en réduisant éventuellement la durée de la mise en contact qui est alors de préférence de 30 secondes à 2 minutes, par exemple de 1 minutes 30 ;
d) on répète éventuellement l'étape b), de 1 à 2 fois ;
e) on sèche la surface.

Avantageusement dans l'étape a) et/ou l'étape c), le pH est maintenu en ajoutant de l'HCl à la solution de HF, généralement à une concentration de 0,5% à 2% en volume, de préférence de 1% en volume de la solution.

Avantageusement dans l'étape a), et/ou l'étape c) un ou plusieurs agents complexants ou oxydants, tels que HCl, sont ajoutés à la solution, de préférence à une concentration de 0,5% à 2% en volume de la solution de façon à maintenir le pH de la solution de rinçage.

Avantageusement l'étape a) et/ou l'étape c) (est) sont mises en oeuvre dans un réservoir muni d'une boucle de recirculation pourvue de préférence d'un filtre de purification, et/ou d'un dégazeur, et/ou d'un purificateur chimique qui élimine la contamination particulaire et métallique, en particulier par les métaux nobles. De préférence encore, ces trois appareils sont présents car une telle configuration à trois appareils permet d'obtenir les meilleures performances.

Avantageusement dans l'étape b) et/ou d), le pH est maintenu par addition d'HCl à l'eau désionisée de façon à obtenir généralement une concentration de 0,01 à 1% en volume.

Avantageusement dans l'étape b) et/ou d), l'agent oxydant est de l'ozone gazeux, ajouté à l'eau désionisée de façon à obtenir une concentration généralement de 3 à 15 ppm, de préférence de 6 ppm.

Avantageusement dans l'étape b) et/ou d), le rinçage est réalisé en présence de mégasons appliqués de préférence pendant une durée supérieure ou égale à 5 minutes, de préférence encore supérieure ou égale à 10 minutes, par exemple de 10 à 20 minutes.

Avantageusement, le séchage de l'étape c) est réalisé en mettant la surface en contact avec de l'isopropanol ("Isopropyl Alcohol" ou IPA) ou par centrifugation.

Avantageusement, l'ensemble du procédé est réalisé à température ambiante : à savoir, généralement de 20 à 30°C, de préférence de 22 à 25°C, par exemple 23°C.

Avantageusement, et préalablement à l'étape a), on procède à une étape dite de « pré-nettoyage » aₒ), par exemple en mettant en contact la surface avec une solution aqueuse contenant de l'ozone généralement à une concentration supérieure ou égale à 6 ppm, de préférence de 6 à 20 ppm, par exemple de 20 ppm, ou avec une solution de H₂SO₄ additionnée de H₂O₂, à savoir généralement additionnée de 0,5% en volume ou moins de H₂O₂, soit généralement dans les proportions de 100 cm³ de H₂O₂ dans H₂SO₄ non dilué. Dans ce dernier cas, la durée de la mise en contact est avantageusement de 5 à 10 minutes, par exemple de 5 minutes.

De préférence, la surface est une surface cristalline et/ou polie

Le procédé selon l'invention présente une suite spécifique d'étapes spécifiques, chacune définie par des conditions opératoires spécifiques, telles que le pH, la température, la durée, et essentiellement la nature et la concentration du ou des réactifs mis en oeuvre.

Un tel procédé n'a jamais été décrit ni suggéré dans l'art antérieur.

Le procédé de l'invention se distingue des procédés de l'art antérieur faisant appel à des réactifs dilués tels que ceux décrits notamment dans les document [4] et [5] en particulier par le fait que dans l'étape b), on maintient le pH à une valeur inférieure à 5, par exemple par addition de HCl. Cela signifie qu'un rinçage acide supplémentaire est réalisé par rapport aux procédés de l'art antérieur. Cette modification des procédés de l'art antérieur tels que ceux des documents [4] et [5] améliore fondamentalement l'efficacité du nettoyage de ces procédés sur les substrats en silicium mais aussi étonnamment sur d'autres substrats.

En d'autres termes, le procédé selon l'invention permet, quel que soit le type de surface nettoyé : Si ou autre, et de manière générale, un nettoyage non rugosifiant, très efficace, et avec une faible consommation de réactifs.

Les améliorations du procédé selon l'invention par rapport aux procédés de l'art antérieur comme ceux des documents [4] et [5] sont obtenus pour les substrats en Si mais aussi avec d'autres substrats tel que notamment les substrats en SiGe.

Par exemple, le retrait de la contamination particulaire et métallique est améliorée sur les substrats en Si et est obtenue de manière excellente, étonnament, aussi sur des substrats en SiGe. Il en est de même pour la faible rugosité de surface et la faible concentration en HF qui sont améliorées lors du traitement de substrats en Si mais sont obtenues aussi étonnament de manière excellente, sur des substrats en SiGe.

Le procédé selon l'invention peut ainsi plus précisément être défini comme un procédé de type « Diluted Dynamic Clean » (« DDC »), qui peut être appliqué aux surfaces d'alliages de silicium-germanium.

Un procédé analogue a déjà été décrit, comme on l'a déjà évoqué plus haut [4] [5], mais il a été mis au point spécifiquement pour le nettoyage de surfaces en silicium et n'a prouvé sa faisabilité et son efficacité que pour le nettoyage de ces surfaces en silicium pour lequel il présentait néanmoins certaines limitations pour les étapes ultérieures de fabrication de dispositifs microélectroniques.

Du fait des différences fondamentales existant entre, d'une part, les surfaces en silicium et, d'autre part, les surfaces en alliage silicium-germanium, un procédé de nettoyage d'une surface en silicium ne peut en aucun cas être transposé directement à une surface en silicium-germanium.

Il ne peut en outre absolument pas être déduit du fait qu'une solution de nettoyage/rinçage et un procédé la mettant en oeuvre, donnent d'excellents résultats pour le nettoyage d'une surface en silicium, que cette même solution va donner aussi d'excellents résultats pour le nettoyage d'une surface en Si-Ge.

En effet, le comportement d'une solution vis-à-vis d'une surface (et vice-versa) est totalement imprévisible et ne peut se déduire de son comportement vis-à-vis d'une surface en un autre matériau.

Il a été mis en évidence de manière étonnante que le procédé selon l'invention de type « DDC » bien que donnant d'excellents résultats sur les substrats en silicium pouvait aussi convenir de manière surprenante à des substrats en Si-Ge et à d'autres substrats.

Le procédé selon l'invention surmonte les inconvénients des procédés de l'art antérieur, répond aux exigences énumérées plus haut, et résout les problèmes des procédés de l'art antérieur.

A savoir, le procédé selon l'invention que l'on peut aussi définir par exemple comme un « nettoyage aqueux à base d'ozone » est un procédé efficace, non rugosifiant, réalisé à température ambiante mettant en oeuvre une chimie HF-ozone qui possède les mêmes fonctions de retrait de la contamination qu'elle soit organique, métallique, particulaire, ou autres, que les chimies classiques de type SC1 et SC2 constituant le procédé de nettoyage RCA, mais qui, par rapport à ce procédé présente de nombreux avantages tels qu'une plus faible consommation de produits chimiques, un temps de cycle réduit, etc.

Le procédé selon l'invention permet d'effectuer un traitement de surface efficace, non rugosifiant, et qui est particulièrement adapté aux surfaces d'alliages Si-Ge, notamment de préférence aux surfaces cristallines, et/ou polies de Si₁₋ₓGeₓ, où x est supérieur à 0 et inférieur à 1, de préférence x est dans la plage de 0,1 à 0,9, de préférence encore de 0,1 à 0,7, mieux encore de 0,2 à 0,5.

Le procédé selon l'invention s'applique particulièrement aux surfaces de Si₁₋ₓGeₓ avec de forts pourcentages en Ge, à savoir de 20 à 70% de germanium.

Le procédé selon l'invention est d'une grande efficacité pouvant aller de 70% à 99% pour toutes les valeurs de x, il peut être réalisé sans adaptation particulière quelle que soit la teneur en germanium de l'alliage. Le procédé selon l'invention n'entraîne dans tous les cas aucune dégradation de la couche d'alliage.

Un procédé de nettoyage plus particulièrement adapté aux surfaces de SiGe répondant par exemple à la formule Si₁₋ₓGeₓ, avec x dans les plages indiquées ci-dessus, comprend les étapes successives suivantes :
a₀) on met la surface en contact avec une solution de H₂SO₄ additionnée de 0,5% en volume ou moins de H₂O₂ (correspondant généralement à environ 100 cm³ de H₂O₂) pendant une durée d'environ 5 minutes ;
a) on met la surface en contact avec une solution de HF et de HCl à des concentrations respectives de 0,2% en volume, et de 1% en volume dans de l'eau désionisée, pendant une durée d'environ 4 minutes ;
b) on rince la surface avec une solution de HCl à 0,01% en volume dans de l'eau désionisée pendant une durée d'environ 3 minutes ;
c) on rince la surface avec une solution de HCl à 0,01% en volume dans de l'eau désionisée dans laquelle ont été injectés 6 ppm de O₃ (concentration), en présence de mégasons généralement, de préférence, pendant une durée telle que mentionnée plus haut pour une telle étape ;
d) on répète l'étape a), la durée de la mise en contact étant de 1 minute 30 environ ;
e) on répète l'étape b) ;
f) on répète l'étape c) ;
g) on sèche la surface.

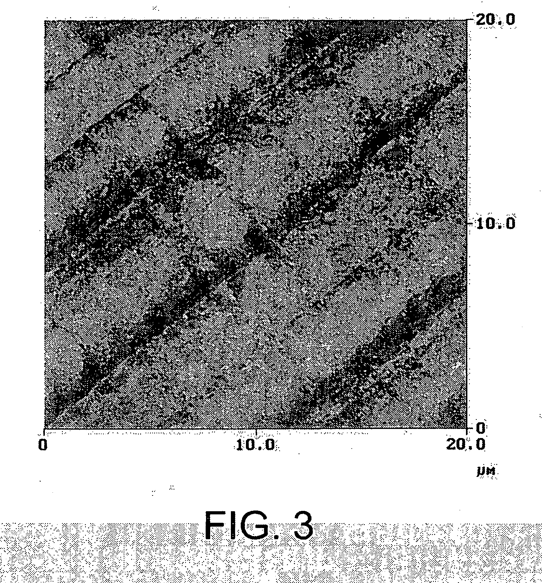

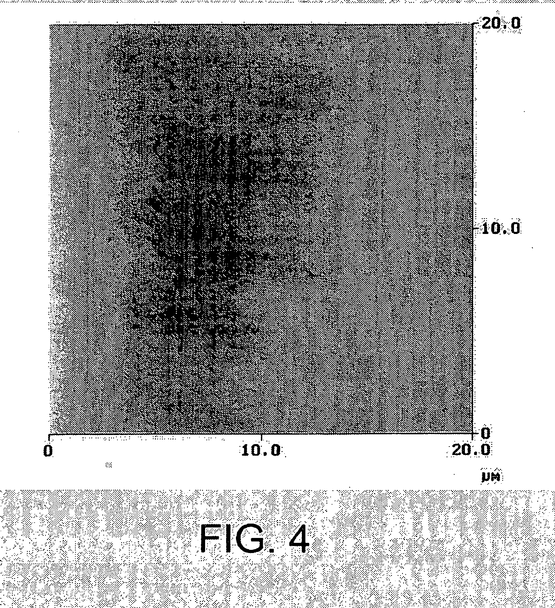

Les avantages présentés par le procédé de l'invention sont entre autres les suivants :
- l'efficacité de retrait particulaire (« PRE ») obtenue après nettoyage par le procédé de l'invention et très élevée, voisine de 90%, et varie selon le contenu en Ge présent dans les alliages, ainsi la PRE est supérieure à 95% pour Si_{0,8}Ge_{0,2} et proche de 85% pour Si_{0,5}Ge_{0,5}. Les défauts résiduels non nettoyés sont attribués à des défauts d'épitaxie ;
- la consommation de matériau SiGe engendrée par le nettoyage par le procédé de l'invention est inférieure et négligeable par rapport à celle obtenue sur silicium. Cette consommation est par exemple de 20 **Å** pour un SiGe à de 20% à 50% Ge. Au contraire, dans un milieu de type RCA, en chimie diluée, la sélectivité importante SiGe/Si, qui est par exemple supérieure ou égale à 4, est principalement fonction de la concentration des solutions utilisées, induisant dans tous les cas une attaque de l'alliage d'autant plus prononcée que le % en Ge augmente ;
- la morphologie de surface obtenue (observation par Microscopie à Force atomique ("AFM")) est lisse, avec une Rₘₛ ("Root mean square", racine carrée moyenne de différents points de surface) généralement < 0,5 nm, plate, c'est-à-dire sans ondulations de surface, et identique à une surface polie, ceci quel que soit le contenu en Ge de l'alliage ; cette morphologie diffère totalement de celle obtenue après un nettoyage de type RCA dilué notamment dès que le contenu en Ge est supérieur à 30% ;
   on pourra à ce sujet se reporter à la figure 3 : surface de Si_{0,5}Ge_{0,5} après nettoyage RCA, Rₘₛ = 0,8 nm et Rₘₐₓ = 8,05 nm ; et à la figure 4 : surface de Si_{0,5}Ge_{0,5} après nettoyage selon l'invention, Rₘₛ = 0,44 nm et Rₘₐₓ : 2,83 nm ; la comparaison visuelle de ces microphotographies et des valeurs de Rₘₛ et Rₘₐₓ démontrent clairement la supériorité du procédé de l'invention ;
- de plus, l'analyse de la contamination métallique révèle l'absence de contaminants métalliques après nettoyage, ou une contamination négligeable, voisine de la limite de détection par une technique de décomposition par spectrométrie de masse ("VPD-ICPMS" "Vapour Phase Decomposition-Inductively Coupled Plasma Mass Spectrometry"), c'est-à-dire une contamination inférieure à 1.10¹⁰ at/cm².

A noter que ce nettoyage peut être réalisé non seulement sur des surfaces Si ou SiGe, mais également sur des substrats silicium sur isolant ("SOI" ou "Silicium On Insulator" en anglais) (la surface est donc en Si), des substrats de silicium contraint sur SiGe sur isolant ("Strained Silicium on SiGe on Insulator" ou SsGOI en anglais) et sur des surfaces composées de matériaux de type A(III) B(V) tels que InP, AsGa, etc..., et d'autres matériaux cristallins épitaxiés par exemple le germanium, en adaptant la durée du procédé et la concentration en HCl et en HF.

Bien entendu, la surface peut être une surface (composite) comprenant plusieurs des matériaux cités ci-dessus.

En conclusion, selon l'invention, le nettoyage peut être réalisé dans des conditions de chimie diluée (HF), sans altérer l'efficacité du retrait de la contamination particulaire et métallique.

L'invention concerne également un procédé de fabrication de dispositifs électroniques, optiques ou opto-électroniques comprenant au moins une étape de nettoyage par voie humide d'une surface en un matériau choisi parmi le silicium, les alliages silicium germanium et les semiconducteurs de type A(III) B(V) par le procédé de nettoyage tel que décrit ci-dessus.

Par exemple, ledit dispositif peut être choisi parmi les dispositifs semiconducteurs complémentaires avec une grille métallique déposée sur une couche d'oxyde ("Complementary Metal-Oxide Semiconductor" ou CMOS en anglais) et les dispositifs tels que les transistors à effet de champ métal-oxyde semiconducteur ("Metal-Oxide Semiconductor Field Effect Transistor" ou MOSFET en anglais).

L'invention va maintenant être décrite de manière détaillée dans la description qui suit, faite en référence aux dessins joints dans lesquels :
- la figure 1 est une vue en coupe schématique des réservoirs utilisés pour la mise en oeuvre d'un procédé « DDC » et du procédé selon l'invention ;
- la figure 2 est un schéma de principe qui montre l'intégration du procédé de nettoyage selon l'invention dans un procédé de préparation de structures microélectroniques ;
- la figure 3 est une microphotographie d'une surface de Si_{0,5}Ge_{0,5} observée par Microscopie à Force Atomique ("AFM") après un nettoyage de type RCA dilué (Exemple 3) ;
- la figure 4 est une microphotographie d'une surface de Si_{0,5}Ge_{0,5} observée par Microscopie à Force Atomique, après un nettoyage par le procédé selon l'invention.

La figure 1 est une vue schématique en coupe verticale qui décrit le système de deux réservoirs ou réservoirs qui sont utilisés pour mettre en oeuvre un procédé de type « Dilated Dynamic Clean » ou « DDC ». Chacun des deux réservoirs, qui sont généralement en quartz, contient un bain chimique. Ce système de réservoir fait partie généralement d'une machine robotisée avec une gestion automatique des bains quant à leur préparation, leur surveillance et leur génération. Ce système a déjà été détaillé plus haut et il est décrit en détail notamment dans les documents [4] et [5] auxquels on pourra se référer. Ce système et cette machine peuvent être également utilisés pour mettre en oeuvre le procédé de l'invention, moyennant quelques adaptations qui peuvent être facilement réalisées par l'homme du métier.

Le procédé selon l'invention est un procédé de nettoyage d'une surface. Par nettoyage, on entend généralement selon l'invention l'élimination de ladite surface de contaminants, polluants dont la présence sur la surface n'est pas souhaitée. Le procédé selon l'invention permet l'élimination de tout contaminant, polluant quelle que soit sa nature. Les contaminants, polluants qui se trouvent sur les surfaces nettoyées par le procédé selon l'invention peuvent être des contaminants, polluants, organiques, minéraux ou métalliques, et ils peuvent se présenter sous la forme de particules ou autres.

Parmi les polluants organiques, on peut citer les hydrocarbures.

Parmi les polluants minéraux, on peut citer par exemple les sels, tels que les nitrates, et le chlorure de sodium.

Même la contamination en particules est éliminée très efficacement par le procédé de l'invention.

Les polluants, contaminants sont par exemple des polluants contaminants issus d'une étape antérieure de traitement de la surface par exemple un polissage mécanochimique.

Le procédé de nettoyage selon l'invention comprend principalement deux étapes de nettoyage qui sont de préférence répétées une fois de sorte que le procédé de nettoyage selon l'invention comprend généralement principalement quatre étapes de nettoyage, provenant de la répétition d'une séquence de deux étapes réalisées dans deux bains chimiques.

Un premier bain chimique (11) de désoxydation se trouve, par exemple, dans le réservoir (10) à boucle de recirculation d'eau désionisée avec une pompe (12) illustré sur la figure 1 : ce bain (11) met en oeuvre une chimie à base de HF diluée par exemple à 1% dans l'eau désionisée, et un second bain (1) de réoxydation se trouve dans le réservoir ou réacteur à débordement (2) pourvu d'un mélangeur statique (8) illustré sur la figure 1 : ce bain met en oeuvre une chimie essentiellement à base d'acide, tel que HCl, dilué dans l'eau désionisée, avec addition éventuelle d'un oxydant fort tel que l'ozone, qui assure un rinçage des substrats dans des conditions oxydantes.

De manière plus précise, la première étape (étape a)) du procédé selon l'invention consiste en une désoxydation de la surface.

Elle a pour but de retirer l'oxyde chimique ou natif de la surface par un mécanisme de gravure, dit « underetching ».

La concentration d'acide fluorhydrique 49% (standard en microélectronique) utilisée doit être telle qu'elle permette une désoxydation complète de la surface. Par exemple, pour désoxyder efficacement des surfaces de SiGe, sans rugosifier la surface de SiGe, une concentration de HF comprise entre 0,2% et 2% en volume peut être, de préférence, utilisée.

De préférence encore, la concentration en HF est de 1% en volume.

La rugosification de la surface ou la tendance aux piqûres (« pitting ») dues à l'oxydation de la surface du silicium en présence de métaux nobles, en milieu HF, doit être évité. Pour cela, des agents oxydants ou complexants, tels que HCl, peuvent être ajoutés. Dans le cas des surfaces de SiGe, une combinaison HF-HCl gazeux, avec des concentrations de HCl comprises de préférence entre 0,5% et 2% en volume, de préférence encore avec une concentration de 1% en volume, permet de maintenir un pH voisin de 1 et favorise un meilleur retrait de la contamination métallique.

Dans cette première étape, d'attaque chimique (« etching »), le temps de désoxydation appliqué doit être généralement suffisant pour retirer l'oxyde chimique ou natif présent initialement en surface. Dans le cas d'un matériau SiGe, le temps de désoxydation est par exemple inférieur à 5 minutes, afin d'éviter une rugosification de la surface par des durées de contact prolongées de HF avec le substrat.

De manière générale, la durée de la mise en contact est fonction notamment du matériau et de l'épaisseur de celui-ci que l'on souhaite enlever.

L'homme du métier adapte cette durée en fonction de la concentration en HF. Par exemple, le temps habituel appliqué sur SiGe est de l'ordre de 4 minutes.

La vitesse d'attaque est déterminée expérimentalement par l'homme du métier au cours d'essais successifs.

Pour éviter une éventuelle contamination du bain par des métaux tels que le Fe, le Cu, et les métaux nobles tels que l'Ag, un filtre de purification ou "purificateur chimique" (15) - à savoir un dispositif renfermant une résine qui complexe les ions métalliques - peut être de préférence installé dans la boucle de recirculation du réservoir, réacteur (10), dans cette étape a) du procédé selon l'invention.

Avantageusement, la propreté des bains est obtenue par l'utilisation de produits de haute pureté (produits "ULSI" et "SULSI", c'est-à-dire "Ultra Large Scale Integration" et "Super Ultra Large Scale Integration" en anglais : il s'agit de produits dont la teneur en particules, métaux, phosphates, nitrates et chlorures est de l'ordre de quelques ppb) dont l'eau désionisée (EDI) est le principal constituant. Le dispositif est généralement complété par une recirculation continue au travers de filtres (13) de 0,1 µm.

Cette étape a) de désoxydation est aussi responsable du soulèvement des particules (appelé « lift-off »), dû à la suppression de l'oxyde, mécanisme qui intervient dans le retrait de la contamination particulaire.

L'utilisation dans cette étape a) du procédé selon l'invention d'une chimie diluée mettant en oeuvre des bains de HF présente l'avantage de réduire la consommation de produits chimiques et la manipulation dangereuse de produits chimiques.

La deuxième étape b) du procédé de l'invention consiste en une reformation ou régénération de l'oxyde qui a été retiré lors de l'étape a). Elle a lieu dans une au de rinçage désionisée et généralement filtrée quant aux particules et entraîne une réoxydation en surface.

Un pH acide, à savoir généralement inférieur à 5, doit être maintenu durant toute la séquence pour favoriser le retrait de la contamination particulaire et maintenir des conditions de répulsion électrostatique. Dans le cas du nettoyage de surfaces, notamment, en SiGe, cela peut se traduire par une faible quantité d'acide HCl, comprise par exemple entre 0,01% et 1%, injectée dans l'eau désionisée durant les premières minutes du rinçage, sans autre ajout de produit chimique. L'acidification peut être réalisée par d'autres acides tels que l'acide nitrique, l'acide acétique ou autres ou des mélanges d'acides.

L'oxydation de la surface est réalisée à température ambiante grâce à l'ajout dans l'EDI d'un agent oxydant puissant. Par exemple, si l'ozone est utilisé comme agent oxydant pour l'oxydation de surfaces de SiGe, une concentration suffisante doit être appliquée, afin de générer rapidement une épaisseur d'oxyde suffisante. La concentration en ozone dans l'eau désionisée est généralement de 3 ppm à 15 ppm, de préférence de 6 ppm à 15 ppm. Pour augmenter l'efficacité de retrait particulaire, une activité acoustique, telle que des mégasons à une fréquence par exemple de 1 à 1,8 MHz, peut être générée pendant quelques minutes. Dans notre cas généralement, une durée minimale de 5 minutes de préférence une durée minimale de 10 minutes, par exemple de 5 à 20 minutes, est appliquée.

Comme on l'a indiqué plus haut, le pH dans la solution de rinçage doit être maintenu acide, à savoir généralement à une valeur inférieure à 5.

Cette séquence de désoxydation - réoxydation (première étape a) et deuxième étape b)) est généralement répétée de 1 à 2 fois, afin d'assurer un retrait optimal de la contamination particulaire et métallique.

Ainsi, dans le cas où l'on répète une fois ces étapes, le procédé selon l'invention comprendra une troisième étape c) et une quatrième étape d).

La troisième étape c) est identique à la première a) en termes de composition en produits chimiques. Seul, le temps de contact avec HF peut être raccourci. Il est généralement compris entre 30 secondes et 2 minutes dans le cas de surfaces Si Ge. En retirant l'oxyde qui vient d'être formé par l'étape précédente d'oxydation, cette attaque amplifie le mécanisme, dit « underetching », nécessaire au retrait des particules.

La quatrième étape d) est identique à la deuxième étape b), en temps et en quantité de produits chimiques injectés. Elle a pour seul but de régénérer l'oxyde retiré lors de la troisième étape, permettant une passivation finale de surface.

Enfin, à l'issue des étapes a) et b), ou à l'issue des étapes c) et d) si les étapes a) et b) sont répétées, on effectue un séchage final par exemple à l'Isopropanol ("Isopropyl Alcohol") ou par centrifugation.

Il faut noter qu'avant les étapes a) et b), éventuellement répétées, une solution chimique peut être ajoutée en amont de la séquence de nettoyage. Cette étape a₀) a pour but de diminuer la contamination organique initiale avant les étapes essentielles de désoxydation et réoxydation. Elle assure plus un pré-nettoyage ou décontamination grossière qu'elle ne répond à une nécessité d'emploi. Cette solution peut être une solution aqueuse contenant de l'ozone, à une concentration inférieure ou égale à 6 ppm (6.10⁻³ g/l) , ou une solution de type « CARO » à base de H₂SO₄ et de H₂O₂ (à 0,5% en volume ou moins) .

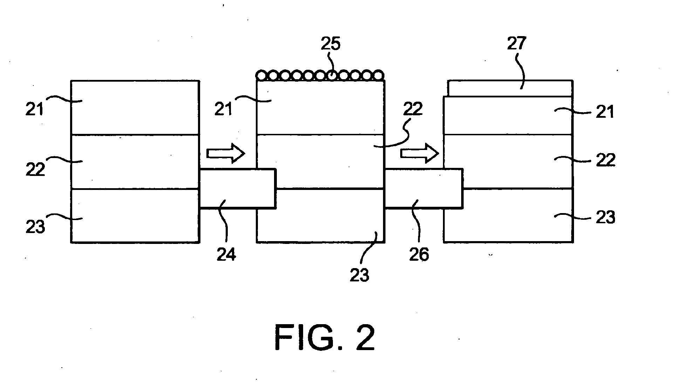

Sur la figure 2, on a illustré la manière selon laquelle le procédé de nettoyage selon l'invention est intégré dans un procédé de préparation de structures microélectroniques.

Une couche de SiGe (21) de composition constante par exemple avec de 20 à 50% de Si, qui se trouve sur une couche de SiGe graduelle (gradient de Ge) (22), elle-même sur un substrat de Si (001) (23), est soumise à une opération de polissage mécanochimique classique (24) ; cette opération de polissage laisse à la surface de la couche de SiGe (21) des impuretés (25) qui comprennent des contaminants organiques, minéraux, métalliques, et particulaires, ces contaminants (25) sont tous éliminés par nettoyage (26) par le procédé de l'invention à l'issue duquel on forme sur la couche de SiGe (21) une couche de Si contraint (27).

On peut ensuite poursuivre le procédé par des étapes classiques qui conduisent à l'obtention de structures telles que des structures "Strained Si-CMOS", "Strained Si-MOSFET" et "Strained SOI-MOSFET".

L'invention va maintenant être décrite en référence aux exemples suivants, donnés à titre illustratif et non limitatif.

### Exemple 1

Dans cet exemple, on effectue le nettoyage, par le procédé selon l'invention, d'un substrat de base possédant la structure suivante :
- substrat relaxé Si_{0,5}Ge_{0,5} <100> d'une épaisseur totale supérieure à 2 µm avec une couche graduelle d'une épaisseur supérieure à 1 µm et une couche de composition constante voisine de 1 µm ;
- ledit substrat relaxé est épitaxié sur substrat de Si <100> légèrement dopé p, 7 à 10 Ω.m.

Le nettoyage, conforme à l'invention, comprend les étapes successives suivantes :
- nettoyage « décontaminant » avec une solution de H₂SO₄ additionnée de 100 cm³ de H₂O₂ : il s'agit de l'étape aₒ) du procédé selon l'invention ;
- nettoyage automatisé se décomposant en deux étapes principales successives :
   . étape 1 : mise en contact du substrat avec une solution de HF comprenant 0,20 % de HF et 1 % de HCl dans l'eau désionisée, pendant une durée de 4 minutes, à température ordinaire, ambiante, (voisine de 20°C) : il s'agit de l'étape a) du procédé selon l'invention, qui permet le retrait de l'oxyde natif chimique présent en surface du substrat ;
   . étape 2 : mise en contact du substrat avec une solution comprenant 0,01 % de HCl dans l'eau désionisée pendant une durée de 3 minutes, puis injection de O₃ gazeux, et poursuite de la mise en contact avec la solution acidifiée à 6 ppm de O₃ pendant une durée de 7 minutes, en présence de mégasons à 1,8 MHz.

Il s'agit de l'étape b) du procédé de l'invention qui permet la reformation d'un oxyde chimique protecteur d'une épaisseur voisine d'environ 20 A.

Les étapes 1 et 2 sont répétées une fois, en utilisant les mêmes conditions opératoires, à l'exception de la durée de la deuxième désoxydation (répétition de l'étape 1) qui n'est plus que de 1 minute 30 secondes au lieu de 4 minutes.

La répétition de ces étapes assure un retrait optimal de la contamination particulaire, issue des résidus de polissage mécano-chimique, voisin de 85 %, qui est seulement limité par la présence de nombreux défauts d'épitaxie en bord de plaque.

A l'issue du nettoyage par le procédé de l'invention, on effectue généralement un nettoyage final par une solution de HF à 0,2%, dit « HF Last » (ce nettoyage ne rentre pas généralement dans le cadre du procédé de l'invention : il s'agit d'un procédé complémentaire), puis un recuit dans une atmosphère d'hydrogène à 800°C, pendant 2 minutes, sous une pression de 20 torrs, suivi d'une reprise d'épitaxie dans un bâti de RP-CVD (dépôt chimique en phase vapeur sous pression réduite), qui permet, à 750°C, la recroissance d'une épaisseur de 50 nm de silicium (chimie « DCS » : DiChloroSilane (SiH₂Cl₂) + Silane (SiH₄)).

### Exemple 2

Dans cet exemple, on effectue le nettoyage par le procédé de l'invention d'un substrat de base possédant la structure suivante :
- substrat reporté Si_{0,8}Ge_{0,2} <100> sur isolant (structure « SGOI » : SiGe sur isolant).

Le nettoyage, conforme à l'invention, comprend les étapes successives suivantes :
- nettoyage décontaminant avec une solution de H₂SO₄ pur (96% en volume : standard en microélectronique), additionnée de 100 cm³ de H₂O₂ : il s'agit de l'étape aₒ) du procédé selon l'invention.
- nettoyage automatisé se décomposant en deux étapes principales successives :
   . étape 1 : mise en contact du substrat avec une solution de HF comprenant 0,20 % de HF et 1 % de HCl dans l'eau désionisée pendant une durée de 4 minutes, à température ordinaire, ambiante (voisine de 20°C) : il s'agit de l'étape a) du procédé selon l'invention, qui permet le retrait de l'oxyde natif ou chimique présent en surface du substrat ;
   . étape 2 : mise en contact du substrat avec une solution comprenant 0,01% de HCl dans l'eau désionisée pendant une durée de 3 minutes, puis injection de O₃ gazeux et poursuite de la mise en contact avec la solution acidifiée à 6 ppm de O₃ pendant une durée de 7 minutes, en présence de mégasons à 1,8 MHz.

Il s'agit de l'étape b) du procédé de l'invention qui permet la reformation d'un oxyde chimique protecteur d'une épaisseur voisine d'environ 20 **Å**.

Les étapes 1 et 2 sont répétées une fois.

A l'issue du nettoyage par le procédé de l'invention, on effectue un nettoyage final au HF dit « HF last », puis un recuit dans une atmosphère d'hydrogène à 800°C, pendant 2 minutes, sous une pression de 20 torrs, suivi d'une reprise d'épitaxie dans un bâti de RP-CVD qui permet, à 750°C, la recroissance de 10 nm de Si_{0,8}Ge_{0,2}, de 10 nm de Si, et de 30 nm de Si_{0,8}Ge_{0,2} (chimie « DCS ») .

### Exemple 3 (comparatif)

On effectue le nettoyage d'une surface de Si_{0,5}Ge_{0,5} par un procédé de type RCA, dans des conditions diluées, à une température inférieure à 40°C.

La surface est tout d'abord traitée par une solution NH₄OH/H₂O₂/H₂O dans un rapport volumique 0,012/1/20 puis par une solution HCl/H₂O₂/H₂O dans un rapport volumique 1/1/80.

La surface obtenue à l'issue du nettoyage est observée par microscopie à Force Atomique ("AFM"). La figure 3 est une microphotographie d'un carré de surface de 20 µm sur 20 µm prise lors de cette observation. La surface traitée a une Rₘₛ de 0,8 nm et une Rₘₐₓ de 8,05 nm.

Cette figure 3 est à comparer à la figure 4 qui est une microphotographie d'un carré de surface de 20 µm sur 20 µm prise lors de l'observation d'une surface par "AFM" à l'issue d'un traitement de nettoyage par le procédé ("DDC") de l'invention.

La surface traitée a une Rₘₛ de 0,44 nm et une Rₘₐₓ de 2,83 nm, très inférieures aux valeurs de la figure 3 (art antérieur).

La simple comparaison visuelle des microphotographies des figures 3 et 4 montre clairement qu'une surface de qualité bien supérieure est obtenue à l'issue du nettoyage par le procédé de l'invention.

### REFERENCES

[1] J.M. Hartmann, B. Gallas, J. Zhang and J.J. Harris, Semicond. Sci. Technol. 15 (2000) 370.
[2] K. Sawano, K. Kawaguchi, T. Ueno, S. Koh, K. Nakagawa and Y. Shiroki, Mat. Sci. Eng. B89 (2002) 406.
[3] K. Sawano, K. Kawaguchi, S. Koh, Y. Hirose, T. Hattori, K. Nakagawa and Y. Shiraki, J. Electrochem. Soc. 150 (2003) G376.
[4] F. Tardif, T. Lardin, P. Boelen, R. Novak and I. Kashkouch, Proceedings of the 3rd International Symposium, UCPSS 1996, 175.
[5] F. Tardif, T. Lardin, A. Danel, P. Boelen, C. Cowache, I. Kashkoush and R. Novak, Proceedings of the 4th International Symposium, UCPSSS 1998, 19.

## Revendications

1. Procédé de nettoyage par voie humide d'une surface en au moins un matériau choisi parmi le silicium, les alliages silicium-germanium, les semiconducteurs de type A(III) B(V), et les matériaux cristallins épitaxiés tels que le germanium, dans lequel on réalise les étapes successives suivantes :
a) on met en contact la surface avec une solution de HF à une concentration de 0,2 à 2% en volume, de préférence de 1% en volume, dans de l'eau désionisée (EDI), pendant une durée inférieure ou égale à 10 minutes, de préférence de 1 à 5 minutes, par exemple de 4 minutes, le pH de ladite solution étant maintenu à une valeur de 1 à 2, de préférence voisine de 1, pendant toute la durée de la mise en contact ;
b) on rince la surface avec de l'eau désionisée et acidifiée, pendant une durée de 1 à 5 minutes, de préférence de 1 à 3 minutes, par exemple de 3 minutes, puis on ajoute un agent oxydant puissant à l'eau désionisée, et on poursuit le rinçage pendant une durée de 5 à 10 minutes, de préférence de 5 à 7 minutes par exemple de 7 minutes ; le pH étant maintenu à une valeur inférieure ou égale à 5., de préférence de 3 à 5, pendant toute l'étape b) ;
c) on répète éventuellement l'étape a), de 1 à 2 fois, en réduisant éventuellement la durée de la mise en contact qui est alors de préférence de 30 secondes à 2 minutes, par exemple de 1 minutes 30
d) on répète éventuellement l'étape b), de 1 à 2 fois ;
e) on sèche la surface.

2. Procédé selon la revendication 1, dans lequel dans l'étape a) et/ou l'étape c), le pH est maintenu en ajoutant de l'HCl à la solution de HF, à une concentration de 0,5 à 2% en volume, de préférence de 1% en volume de la solution.

3. Procédé selon l'une quelconque des revendications 1 et 2, dans lequel dans l'étape a) et/ou l'étape c), un ou plusieurs agents complexants ou oxydants, tels que HCl, sont ajoutés à la solution, de préférence à une concentration de 0,5 à 2% en volume de la solution.

4. Procédé selon l'une quelconque des revendications précédentes, dans lequel l'étape a) et/ou l'étape c) est (sont) mise(s) en oeuvre dans un réacteur muni d'une boucle de recirculation pourvue de préférence d'un filtre de purification, et/ou d'un dégazeur, et d'un purificateur chimique destiné à éliminer la contamination particulaire et métallique.

5. Procédé selon l'une quelconque des revendications précédentes, dans lequel dans l'étape b) et/ou l'étape d), le pH est maintenu par addition d'acide chlorhydrique à l'eau désionisée de façon à obtenir une concentration de 0,01 à 1% en volume.

6. Procédé selon l'une quelconque des revendications précédentes, dans lequel dans l'étape b) et/ou l'étape d), l'agent oxydant est de l'ozone gazeux, ajouté à l'eau désionisée de façon à obtenir une concentration de 3 à 15 ppm, de préférence de 6 ppm.

7. Procédé selon l'une quelconque des revendications précédentes, dans lequel dans l'étape b) et/ou l'étape d), le rinçage est réalisé en présence de mégasons.

8. Procédé selon la revendication 7, dans lequel les mégasons sont appliqués pendant une durée supérieure ou égale à 5 minutes, de préférence supérieure ou égale à 10 minutes, par exemple de 10 à 20 minutes.

9. Procédé selon l'une quelconque des revendications précédentes, dans lequel le séchage de l'étape c) est réalisé en mettant la surface en contact avec de l'isopropanol.

10. Procédé selon l'une quelconque des revendications 1 à 8, dans lequel le séchage de l'étape c) est réalisé par centrifugation.

11. Procédé selon l'une quelconque des revendications précédentes, dans lequel l'ensemble du procédé est réalisé à température ambiante.

12. Procédé selon l'une quelconque des revendications précédentes, dans lequel, préalablement à l'étape c) on procède à une étape de prénettoyage a₀) en mettant en contact la surface avec une solution aqueuse contenant de l'ozone à une concentration supérieure ou égale à 6 ppm, ou avec une solution de H₂SO₄ additionnée de H₂O₂.

13. Procédé selon l'une quelconque des revendications 1 à 12, dans lequel la surface est en un alliage de silicium germanium de formule Si₁₋ₓGeₓ avec x supérieur à 0 et inférieur à 1, de préférence x est dans la plage de 0,1 à 0,9, de préférence encore de 0,1 à 0, 7, et mieux de 0,2 à 0,5.

14. Procédé selon l'une quelconque des revendications précédentes, dans lequel la surface est une surface cristalline et/ou polie, de préférence de Si₁₋ₓGeₓ.

15. Procédé selon la revendication 13, dans lequel on réalise les étapes successives suivantes :
a₀) on met la surface en contact avec une solution de H₂SO₄ additionnée de 0,5% en volume ou moins de H₂O₂ pendant une durée d'environ 5 minutes ;
a) on met la surface en contact avec une solution de HF et de HCl à des concentrations respectives de 0,2% en volume, et de 1% en volume dans de l'eau désionisée, pendant une durée d'environ 4 minutes ;
b) on rince la surface avec une solution de HCl à 0,01% en volume dans de l'eau désionisée pendant une durée d'environ 3 minutes ;
c) on rince la surface avec une solution de HCl à 0,01% en volume dans de l'eau désionisée dans laquelle ont été injectés 6 ppm de O₃, en présence de mégasons ;
d) on répète l'étape a), la durée de la mise en contact étant de 1 minute 30 environ ;
e) on répète l'étape b) ;
f) on répète l'étape c) ;
g) on sèche la surface.

16. Procédé de fabrication d'un dispositif électronique, optique ou opto-électronique comprenant au moins une étape de nettoyage par voie humide d'une surface en un matériau choisi parmi le silicium, les alliages silicium-germanium, les semiconducteurs de type A(III) B(V), et les matériaux cristallins épitaxiés tels que le germanium, par le procédé selon l'une quelconque des revendications 1 à 15.

17. Procédé selon la revendication 16, dans lequel ledit dispositif est choisi parmi les dispositifs semiconducteurs complémentaires avec une grille métallique déposée sur une couche d'oxyde ("Complementary Metal-Oxide Semiconductor" ou CMOS en anglais) et les dispositif de transistor à effet de champ métal-oxyde semiconducteur ("Metal-Oxide Semiconductor Field Effect Transistor" ou MOSFET en anglais).

## Claims

1. Method of wet cleaning a surface of at least one material chosen from among silicon, silicon-germanium alloys, A(III) B(V)-type semiconductors and epitaxially grown crystalline materials such as germanium, in which the following successive steps are carried out:
a) the surface is brought into contact with an HF solution with a concentration of 0.2 to 2% by volume, preferably 1% by volume, in deionised water (DIW), for a time period of less than or equal to 10 minutes, preferably 1 to 5 minutes, for example 4 minutes, the pH of said solution being maintained at a value of from 1 to 2, preferably close to 1, throughout the entire contact time;
b) the surface is rinsed with acidified, deionised water for a time period of 1 to 5 minutes, preferably 1 to 3 minutes, for example 3 minutes, then a powerful oxidising agent is added to the deionised water, and the rinsing is continued for a time period of 5 to 10 minutes, preferably 5 to 7 minutes, for example 7 minutes; the pH being maintained at a value less than or equal to 5, preferably 3 to 5, throughout the entire step b);
c) optionally, step a) is repeated, one to two times, while optionally reducing the contact time, which is then preferably from 30 seconds to 2 minutes, for example 1 minute 30 seconds;
d) step b) is optionally repeated, one to two times;
e) the surface is dried.

2. Method of claim 1, wherein, in step a) and/or step c), the pH is maintained by adding HCl to the HF solution, at a concentration of 0.5 to 2% by volume, preferably 1% by volume, of the solution.

3. Method as claimed in any of claims 1 and 2, wherein, in step a) and/or step c), one or more complexing or oxidising agents, such as HCl, are added to the solution, preferably at a concentration of 0.5 to 2% by volume, of the solution.

4. Method as claimed in any of the preceding claims, wherein step a) and/or step c) is (are) carried out in a reactor provided with a recirculation loop preferably provided with a purifying filter and/or a degasser, and with a chemical purifier intended to eliminate the particulate or metallic contamination.

5. Method as claimed in any of the preceding claims, wherein, in step b) and/or step d), the pH is maintained by adding hydrochloric acid to the deionised water so as to obtain a concentration of 0.01 to 1% by volume.

6. Method as claimed in any of the preceding claims, wherein, in step b) and/or step d), the oxidising agent is gaseous ozone, added to the deionised water so as to obtain a concentration of 3 to 15 ppm, preferably 6 ppm.

7. Method as claimed in any of the preceding claims, wherein, in step b) and/or step d), the rinsing is carried out in the presence of megasonic waves.

8. Method of claim 7, wherein the megasonic waves are applied for a time period greater than or equal to 5 minutes, preferably greater than or equal to 10 minutes, for example 10 to 20 minutes.

9. Method as claimed in one of the preceding claims, wherein the drying of step c) is carried out by bringing the surface into contact with isopropanol.

10. Method as claimed in any of claims 1 to 8, wherein the drying of step c) is carried out by centrifugation.

11. Method as claimed in any of the preceding claims, wherein the entire method is carried out at ambient temperature.

12. Method as claimed in any one of the preceding claims, wherein, prior to step c), a precleaning step a₀) is carried out by bringing the surface into contact with an aqueous solution containing ozone at a concentration greater than or equal to 6 ppm, or with a solution of H₂SO₄ to which H₂O₂ has been added.

13. Method as claimed in any of claims 1 to 12, wherein the surface is made of a silicon-germanium alloy having the formula Si₁₋ₓGeₓ with x being greater than 0 and less than 1, with x preferably being in the range of 0.1 to 0.9, more preferably from 0.1 to 0.7, and better yet from 0.2 to 0.5.

14. Method as claimed in any of the preceding claims, wherein the surface is a crystalline and/or polished surface, preferably of Si₁₋ₓGeₓ.

15. Method of claim 13, wherein the following successive steps are carried out:
a₀) the surface is brought into contact with an H₂SO₄ solution to which 0.5 vol % or less of H₂O₂ has been added, for a time period of approximately 5 minutes;
a) the surface is brought into contact with an HF and HCl solution, having respective concentrations of 0.2% by volume and 1% by volume, in deionised water, for a time period of approximately 4 minutes;
b) the surface is rinsed with a 0.01% by volume HCl solution in deionised water for a time period of approximately 3 minutes;
c) the surface is rinsed with a 0.01% by volume HCl solution in deionised water, into which 6 ppm of O₃ has been injected, in the presence of megasonic waves;
d) step a) is repeated, the contact time being approximately 1 minute 30 seconds;
e) step b) is repeated;
f) step c) is repeated;
g) the surface is dried.

16. Method of manufacturing an electronic, optical or optoelectronic device comprising at least one step of wet cleaning a surface made of a material chosen from among silicon, silicon-germanium alloys, A(III) B(V)-type semiconductors and epitaxially grown crystalline materials, such as germanium, by the method as claimed in any one of claims 1 to 15.

17. Method of claim 16, wherein said device is chosen from among Complementary Metal-Oxide Semiconductor (CMOS) devices and Metal-Oxide Semiconductor Field-Effect Transistor (MOSFET) devices.

## Patentansprüche

1. Verfahren zum Nassreinigen einer Oberfläche aus wenigstens einem Material, ausgewählt unter Silicium, den Silicium-Germanium-Legierungen, den Halbleitern des Typs A(III) B(V), und den epitaxierten kristallinen Materialien wie etwa Germanium, in dem man die folgenden aufeinanderfolgenden Schritte realisiert:
a) man bringt die Oberfläche in Kontakt mit einer HF-Lösung mit einer Konzentration von 0,2 bis 2 Vol.-%, vorzugsweise 1 Vol.-%, in entionisiertem Wasser während einer Dauer von unter oder gleich 10 Minuten, vorzugsweise 1 bis 5 Minuten, zum Beispiel 4 Minuten, wobei der pH der genannten Lösung während der gesamten Dauer des Kontakts auf einem Wert von 1 bis 2 gehalten wird, vorzugsweise in der Nähe von 1;
b) man spült die Oberfläche mit entionisiertem und gesäuertem Wasser während einer Dauer von 1 bis 5 Minuten, vorzugsweise 1 bis 3 Minuten, zum Beispiel 3 Minuten, mischt dann dem entionisierten Wasser ein starkes Oxidationsmittel bei und setzt die Spülung während einer Dauer von 5 bis 10 Minuten und vorzugsweise 5 bis 7 Minuten fort, zum Beispiel 7 Minuten; der pH wird während des gesamten Schritts b) auf einem Wert unter oder gleich 5 und vorzugsweise von 3 bis 5 gehalten;
c) man wiederholt eventuell Schritt a) 1- bis 2-mal, wobei man eventuell die Dauer des Kontakts reduziert, die dann vorzugsweise von 30 Sekunden bis 2 Minuten beträgt, zum Beispiel eineinhalb Minuten;
d) man wiederholt eventuell Schritt b) 1- bis 2-mal;
e) man trocknet die Oberfläche.

2. Verfahren nach Anspruch 1, in dem in Schritt a) und/oder Schritt c) der pH aufrechterhalten wird, indem der HF-Lösung HCl beigemischt wird, mit einer Konzentration von 0,5 bis 2 Vol.-% und vorzugsweise 1 Vol.-% der Lösung.

3. Verfahren nach einem der Ansprüche 1 und 2, in dem in Schritt a) und/oder Schritt c) der Lösung ein oder mehrere komplexierende oder oxidierende Mittel beigemischt werden, vorzugsweise mit einer Konzentration von 0,5 bis 2 Vol.-% der Lösung.

4. Verfahren nach einem der vorangehenden Ansprüche, in dem Schritt a) und/oder Schritt c) in einem Reaktor ausgeführt werden (wird), der eine Rezirkulationsschleife, vorzugsweise ausgestattet mit einem Reinigungsfilter, und/oder einen Entgaser und einen chemischen Reiniger zur Eliminierung der Partikel- und Metallkontamination umfasst.

5. Verfahren nach einem der vorangehenden Ansprüche, in dem in Schritt b) und/oder Schritt d) der pH aufrechterhalten wird, indem dem entionisierten Wasser Salzsäure beigemischt wird, um eine Konzentration von 0,01 bis 1 Vol.-% zu erhalten.

6. Verfahren nach einem der vorangehenden Ansprüche, in dem in Schritt b) und/oder Schritt d) das Oxidationsmittel gasförmiges Ozon ist, dem entionisierten Wasser beigemischt wird, um eine Konzentration von 3 bis 15 ppm und vorzugsweise 6 ppm zu erhalten.

7. Verfahren nach einem der vorangehenden Ansprüche, in dem in Schritt b) und/oder Schritt d) die Reinigung in Präsenz von Megatönen realisiert wird.

8. Verfahren nach Anspruch 7, in dem die Megatöne während einer Dauer von über oder gleich 5 Minuten, vorzugsweise von über oder gleich 10 Minuten und zum Beispiel von 10 bis 20 Minuten angewendet werden.

9. Verfahren nach einem der vorangehenden Ansprüche, in dem die Trocknung des Schritts c) realisiert wird, indem man die Oberfläche in Kontakt mit Isopropanol bringt.

10. Verfahren nach einem der Ansprüche 1 bis 8, in dem die Trocknung in Schritt c) durch Zentrifugation realisiert wird.

11. Verfahren nach einem der vorangehenden Ansprüche, in dem das gesamte Verfahren bei Umgebungstemperatur realisiert wird.

12. Verfahren nach einem der vorangehenden Ansprüche, in dem man vor dem Schritt c) einen Vorreinigungsschritt a₀) ausführt, indem man die Oberfläche in Kontakt bringt mit einer wässrigen Lösung, die Ozon mit einer Konzentration von über oder gleich 6 ppm enthält, oder mit einer H₂SO₄-Lösung mit beigemischtem H₂O₂.

13. Verfahren nach einem der Ansprüche 1 bis 12, in dem die Oberfläche aus einer Silicium-Germanium-Legierung der Formel Si₁₋ₓGeₓ mit x größer als 0 und kleiner als 1, wobei x vorzugsweise enthalten ist in dem Bereich von 0,1 bis 0,9, noch besser von 0,1 bis 0,7 und am besten von 0,2 bis 0,5.

14. Verfahren nach einem der vorangehenden Ansprüche, in dem die Oberfläche eine kristalline und/oder polierte Oberfläche ist, vorzugsweise aus Si₁₋ₓGeₓ.

15. Verfahren nach Anspruch 13, in dem man die folgenden aufeinanderfolgenden Schritte realisiert:
a₀) man bringt die Oberfläche während einer Dauer von ungefähr 5 Minuten in Kontakt mit einer H₂SO₄-Lösung, der 0,5 Vol.-% oder weniger H₂O₂ beigemischt sind;
a) man bringt die Oberfläche während einer Dauer von ungefähr 4 Minuten in Kontakt mit einer Lösung von HF und HCl mit Konzentrationen von jeweils 0,2 Vol.-% und 1 Vol.-% in entionisiertem Wasser;
b) man spült die Oberfläche mit einer Lösung von 0,01 Vol.-% HCl in entionisiertem Wasser während einer Dauer von 3 Minuten;
c) man spült die Oberfläche mit einer Lösung von 0,01 Vol.-% HCl in entionisiertem Wasser, in das man 6 ppm O₃ injiziert hat, in Präsenz von Megatönen;
d) man wiederholt Schritt a), wobei die Dauer des Kontakts ungefähr eineinhalb Minuten beträgt;
e) man wiederholt Schritt b);
f) man wiederholt Schritt c);
g) man trocknet die Oberfläche.

16. Verfahren zur Herstellung einer elektronischen, optischen oder optoelektronischen Vorrichtung mit wenigstens einem Schritt zum Nassreinigen einer Oberfläche aus einem Material, ausgewählt unter Silicium, den Silicium-Germanium-Legierungen, den Halbleitern des Typs A(III) B(V) und den Epitaxierten kristallinen Materialien wie etwa Germanium, durch ein Verfahren nach einem der Ansprüche 1 bis 15.

17. Verfahren nach Anspruch 16, in dem die genannte Vorrichtung ausgewählt wird unter den komplementären Halbleitervorrichtungen mit einem metallischen Gitter bzw. einer Gitterelektrode, abgeschieden auf einer Oxidschicht ("Complementary Metal-Oxide Semiconductor" oder CMOS) und den Transistorvorrichtungen des Typs Metalloxid-Halbleiter-FET ("Metal-Oxide Semiconductor Field Effect Transistor" oder MOSFET).
